(19) Europäisches Patentamt
European Patent Office
Office européen des brevets

(11) **EP 3 264 610 A1**

(12) **EUROPEAN PATENT APPLICATION**

(43) Date of publication:
**03.01.2018 Bulletin 2018/01**

(51) Int Cl.:
***H03M 13/11*** *(2006.01)*  ***H03M 13/00*** *(2006.01)*
***H04L 1/00*** *(2006.01)*

(21) Application number: **16305774.8**

(22) Date of filing: **27.06.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ALCATEL LUCENT**
**92100 Boulogne-Billancourt (FR)**

(72) Inventors:
• **RAZZETTI, Luca**
**20871 VIMERCATE (IT)**

• **GAVIOLI, Giancarlo**
**20871 VIMERCATE (IT)**
• **COSTANTINI, Carlo**
**20871 VIMERCATE (IT)**
• **CATTANEO, Davide**
**20871 VIMERCATE (IT)**

(74) Representative: **Pietra, Giulia et al**
**Marchi & Partners S.r.l.**
**Via Vittor Pisani, 13**
**20124 Milano (IT)**

(54) **FORWARD ERROR CORRECTION WITH VARIABLE CODING RATE**

(57) It is disclosed a method for implementing a forward error correction mechanism in an optical coherent communication system comprising a FEC encoder and a FEC decoder. The FEC encoder encodes blocks of client bits into codewords by adding parity bits calculated by applying a FEC code to the client bits. Besides, the FEC decoder decodes each codeword by applying thereto an iterative message-passing algorithm, each iteration of the message-passing algorithm comprising evaluating a parity-check matrix defining the FEC code. At the FEC encoder, the coding rate of the FEC code may be varied by varying the number of client bits per codeword (using the principle of information shortening) and/or the number of parity bits per codeword (using the principle of cdoe expanding). At the FEC decoder, the parity-check matrix is evaluated column by column at each iteration of the column-layered message-passing algorithm. The computational complexity of the FEC decoder is advantageously weakly dependent and, in some cases, totally independent of the coding rate.

Figure 2

EP 3 264 610 A1

**Description**

**Technical field**

The present invention generally relates to the field of communication networks. In particular, the present invention relates to a method for implementing a Forward Error Correction (FEC) mechanism having a variable coding rate in a communication network, and to an optical coherent communication system configured to implement this method.

**Background art**

As known, Forward Error Correction (FEC) is a technique for detecting and possibly correcting errors in digital data transmissions between network elements of a digital communication network, e.g. a Wavelength Division Multiplexing (WDM) communication network.

According to FEC, at the transmitting side the digital data to be transmitted are encoded using an error correcting code which adds redundancy. At the receiving side, the redundancy is used to detect, and possibly to correct, errors in the original data.

Different types of error correcting codes are known, including block codes and convolutional codes. In block codes, the digital data to be transmitted are divided into fixed-size blocks of n client bits and each block is separately encoded into a respective codeword of n+k bits by adding k redundancy bits.

A block code is defined by a set of rules for calculating the k redundancy bits starting from the n client bits. For instance, in parity-check codes, each one of the k redundancy bits is calculated as the parity (namely, the modulo-2 addition) of a certain subset of the n client bits, and is therefore also termed "parity bit". Each rule corresponds to a respective parity check, which basically provides for checking whether the modulo-2 addition of the parity bit and the subset of the n client bits used for calculating it is equal to zero. A codeword is valid only if all the parity checks are satisfied.

A parity-check code may be also expressed in the form of a binary matrix (also termed parity-check matrix) with k rows corresponding to the k parity checks and n+k columns corresponding to the n+k bits of the codeword.

Amongst the parity-check codes, Low-Density Parity-Check (LDPC) codes are known and presently widely used in WDM communication networks. LDPC codes have parity-check matrixes that contain only a very small number of non-zero entities (namely, they are sparse matrixes). The sparseness of the parity-check matrix guarantees both a decoding complexity which increases only linearly with the code length and a minimum distance which also increases linearly with the code length.

LDPC codes are often represented in graphical form by a Tanner graph. A Tanner graph basically consists of a first column of n+k nodes called "variable nodes" and a second column of k nodes called "check nodes". Each variable node corresponds to a respective codeword bit (either a client bit or a parity bit), while each check node corresponds to a respective parity check. In the graph, codeword bits involved in a certain parity check have their variable nodes joined with the check node of that parity check. This provides an intuitive graphical representation of the parity checks that define the LDPC code.

LDPC codes are typically decoded using iterative algorithms known as "message-passing algorithms", wherein variable nodes and check nodes act like state machines iteratively exchanging messages and updating their states. Different types of message-passing algorithms are known, which differ for the content of the exchanged messages and for the processing carried out at variable nodes and check nodes.

A particular class of message-passing algorithms is that of the so-called "belief propagation algorithms", wherein the messages exchanged between a variable node corresponding to a certain codeword bit and the neighboring check nodes comprise probabilities that the codeword bit has the value 1 or 0. The probability of a codeword bit being equal to 1 or 0 is often expressed as a so-called "log likelihood ratio" (or, briefly, LLR), namely:

$$LLR = \log_{10}\left(\frac{p(0)}{p(1)}\right), \qquad\qquad [1]$$

where p(0) and p(1) are the probabilities that the codeword bit is equal to 0 and to 1, respectively. An LLR>0 indicates that the codeword bit is more probably 0 than 1, while an LLR<0 indicates that the codeword bit is more probably 1 than 0. Besides, LLR=0 indicates that the probabilities that the codeword bit is 1 or 0 are the same. Exemplary belief propagation algorithms making use of LLR are e.g. the "sum-product" algorithm (SPA) and the "min-sum" algorithm (MSA).

According to belief propagation algorithms, each variable node firstly receives as input an a priori probability of its codeword bit, which is provided thereto by a preceding component of the receiver, typically the demodulator. Then, each variable node calculates an a posteriori probability of its codeword bit, which takes into account both the a priori probability and extrinsic information provided by its neighboring check nodes. The a posteriori probability of each codeword bit is gradually refined by iterating a sequence of steps including: transmission of the a posteriori probabilities from the variable nodes to their neighboring check nodes, processing of the received a posteriori probabilities by the check nodes resulting in updated extrinsic information, transmission of the updated extrinsic information from the check nodes to the neighboring variable nodes, and processing of the updated extrinsic information at the variable nodes resulting in updated a posteriori probabilities. After a predefined number of iterations, the algorithm ends and the final value of the a posteriori probabilities may be used for taking a hard decision on (namely, assigning the value 0 or 1 to) the codeword bits.

From the implementation point of view, a message-passing algorithm is typically implemented by a FEC decoder comprising a number of cascaded decoding blocks, one per each iteration of the algorithm. Each decoding block receives from the preceding block the a posteriori probabilities or the extrinsic information calculated at the previous iteration, and calculates new, refined a posteriori probabilities or new, refined extrinsic information. The last decoding block may then pass the a posteriori probabilities to a hard decision block, which takes a hard decision for each codeword bit.

As it is known, in order to reduce the number of iterations needed to make the LDPC decoding converge (and hence to reduce the number of decoding blocks needed at the FEC decoder), layered decoding schemes can be used. Layered LDPC decoding schemes may be either row-layered or column-layered.

According to row-layered LDPC decoding schemes, the message updating at each iteration is performed by scanning the parity-check matrix row by row. In other words, each iteration of the message-passing algorithm is divided into a sequence of k steps, each step comprising the update of the states of a check node and the variable nodes connected thereto.

Besides, according to column-layered LDPC decoding schemes, the message updating at each iteration is performed by scanning the parity-check matrix column by column. In other words, each iteration of the message-passing algorithm is divided into a sequence of n+k steps, each step comprising the update of the states of a variable node and the check nodes connected thereto.

As known, for a parity check code (an in particular, for an LDPC code) a coding rate R may be defined as:

$$R = \frac{n}{n+k}, \qquad [2]$$

Where n is the number of client bits per codeword and k is the number of parity bits per codeword. The coding rate R may be expressed also as:

$$R = \frac{f_C}{f_L} = \frac{f_C}{f_C + f_P}, \qquad [3]$$

where $f_C = n/T$ is the client bitrate, $f_P = k/T$ is the parity bitrate and $f_L$ is the line bitrate defined as $f_L = f_C + f_P = (n+k)/T$, T being the codeword period. Hence, for a certain client bitrate $f_C$, the higher the parity bitrate $f_P$, the lower the coding rate R and the higher the error detection and correction capability of the code.

Techniques are known for varying the coding rate of an LDPC code, in particular for lowering it from a maximum starting value $R_0$, such as information shortening and code expanding.

According to the known information shortening technique, the coding rate $R_0$ of an LDPC code defined by $k_0$ parity checks calculated on blocks of $n_0$ client bits is reduced to a new value $R_N$ by reducing the number of client bits per codeword from $n_0$ to $n_N < n_0$, while keeping the number of parity bits equal to $k_0$. To this purpose, codewords are formed that comprise $n_N$ client bits and $k_0$ parity bits calculated by applying the $k_0$ parity checks on $n_0$ bits including the $n_N$ client bits of the codeword and $n_N - n_0$ zeros. The $n_N - n_0$ zeroes are not transmitted. At the decoder, an infinite probability is assigned to the $n_N - n_0$ variable nodes corresponding to the $n_N - n_0$ not transmitted zeroes, and then a belief propagation algorithm as described above is applied in order to detect and correct errors in the $n_N$ client bits of the codeword.

According to the known code expanding technique, the coding rate $R_0$ of an LDPC code defined by $k_0$ parity checks calculated on blocks of $n_0$ client bits, is reduced to a new value $R_N$ by increasing the number of parity bits per codeword from $k_0$ to $k_N$ with $k_N > k_0$, while keeping the number of client bits equal to $n_0$. To this purpose, codewords are formed that comprise $n_0$ client bits, $k_0$ parity bits calculated by applying the $k_0$ parity checks on the $n_0$ client bits and $k_N - k_0$ further parity bits calculated by applying $k_N - k_0$ further parity checks on the $n_0$ client bits.

According to both information shortening and code expanding, therefore, the coding rate $R_0$ of an LDPC code is decreased to a new value $R_N$ by introducing a change in the relative size of payload (client bits) and overhead (parity bits) of the codeword. Such change in both cases entails a change in the parity bitrate, which may in turn result in a change of the client bitrate and/or in a change of the line bitrate.

In particular, according to both information shortening and code expanding, the coding rate scales with the client bitrate $f_C$ and the parity bitrate $f_P$ according to the following equation:

$$\frac{R_N}{R_0} = \frac{f_{CN}}{f_{C0}} \cdot \frac{f_{L0}}{f_{LN}} = \frac{f_{CN}}{f_{C0}} \cdot \frac{f_{C0} + f_{P0}}{f_{CN} + f_{PN}}, \qquad [4]$$

where $f_{C0}$, $f_{P0}$ and $f_{L0}$ are the client bitrate, parity bitrate and line bitrate at the original coding rate $R_0$ (with $f_{L0} = f_{C0} + f_{P0}$), whereas $f_{CN}$, $f_{PN}$ and $f_{LN}$ are the client bitrate, parity bitrate and line bitrate at the new, decreased coding rate $R_N < R_0$ (with $f_{LN} = f_{CN} + f_{PN}$).

## Summary of the invention

The inventors have noticed that in coming generations of devices for optical coherent transmission, optical coherent receivers will be implemented as CMOS devices hosting several client channels - with a typical bitrate of 100 Gbps - in a single monolithic chip (DSP chip).

In order to perform a FEC decoding of each client channel, the DSP chip shall comprise a number of FEC decoders (in particular, LDPC decoders), which represent the major contributors to the computational complexity and power consumption of the entire DSP chip.

On the other hand, the inventors have noticed that a trend in devices for optical coherent transmission is that of providing them with more and more flexibility, meaning that a same DSP chip shall be reconfigurable to operate under different operating conditions, namely with different client bitrates and/or different line bitrates. In particular, the DSP chip shall be capable of adjusting the coding rate R of the FEC code so as to maximize the error detection and correction capability of the FEC code in each operating condition.

In particular, two different scenarios may be envisaged:

(i) line bitrate $f_L$ fixed and client bitrate $f_C$ variable. In this case, if the client bitrate $f_C$ decreases, the parity bitrate $f_P$ may be increased (namely, the coding rate R may be decreased) so as to exploit the line bitrate $f_L$ left unused at the purpose of increasing the error detection and correction capability of FEC; or

(ii) client bitrate $f_C$ fixed and line bitrate $f_L$ variable. In this case, if the line bitrate $f_L$ increases, the parity bitrate $f_P$ may be increased (namely, the coding rate R may be decreased) so as to exploit the increased line bitrate $f_L$ at the purpose of increasing the error detection and correction capability of FEC.

Besides, the inventors have noticed that the devices for optical coherent transmission of the coming generation shall be compatible with legacy devices already deployed.

In principle, the above described techniques for varying the coding rate of LDPC codes (information shortening and code expanding) could provide DSP chips for optical coherent transmission with the above flexibility while preserving their interoperability with the legacy devices.

However, the inventors have noticed that implementing a FEC decoder capable of decoding an LDPC code with coding rate variable according to information shortening and/or code expanding involves other issues.

In particular, the inventors have noticed that a FEC decoder implementing a belief propagation algorithm using a row-layered LDPC decoding scheme, for each received codeword performs a sequence of k operations at each iteration of the algorithm, each operation consisting in evaluating a respective row of the parity-check matrix as described above. Thus, the computational complexity of such known row-layered FEC decoder, which is defined as the number of operations per received codeword, can be expressed as:

$$C(row) = \frac{k}{T} = \frac{1-R}{R} \cdot \frac{n}{T} = \frac{1-R}{R} \cdot f_C = f_P, \qquad [5]$$

where T is the codeword period, R is the coding rate of the LDPC code, $f_C$ is the client bitrate and $f_P$ is the parity bitrate. The complexity therefore basically depends on the parity bitrate.

Hence, the computational complexity of a FEC decoder applying a row-layered decoding scheme to an LDPC code whose coding rate is varied using either information shortening or code expanding scales with the coding rate as follows:

$$\frac{C_N(\text{row})}{C_0(\text{row})} = \frac{R_0}{R_N} \cdot \frac{1-R_N}{1-R_0} \cdot \frac{f_{CN}}{f_{C0}} = \frac{1-R_N}{1-R_0} \cdot \frac{f_{LN}}{f_{L0}} = \frac{f_{PN}}{f_{P0}} , \qquad [6]$$

where $f_{C0}$ $f_{P0}$ and $f_{L0}$ are the client bitrate, parity bitrate and line bitrate at the original coding rate $R_0$, whereas $f_{CN}$, $f_{PN}$ and $f_{LN}$ are the client bitrate, parity bitrate and line bitrate at the new, decreased coding rate $R_N < R_0$.

From equation [6] it is apparent that the computational complexity of a FEC decoder applying a row-layered decoding scheme significantly increases as the coding rate is decreased. This is because the computational complexity scales with the parity bitrate, which increases as the coding rate is decreased either by reducing the number of client bits per codeword (information shortening) or by increasing the number of parity bits per codeword (code expanding).

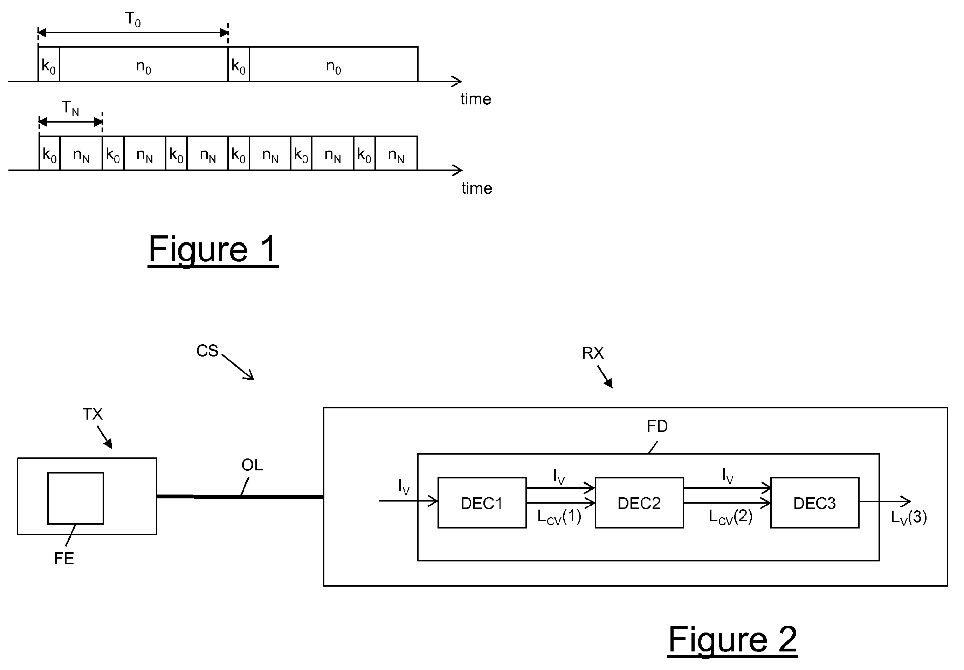

This is schematically depicted in Figure 1, showing an exemplary scenario where the line bitrate $f_L$ is fixed and the coding rate is increased by reducing the number of client bits per codeword from $n_0$ to $n_N$, while keeping the number of parity bits per codeword equal to $k_0$. It may be appreciated that the codeword length is reduced from $n_0+k_0$ to $n_N+k_0$ and, since the line bitrate $f_L$ is fixed, the codeword period is also reduced from $T_0$ to $T_N$. This entails an increase of the parity bitrate, even if the number of parity bits per codeword is kept equal to $k_0$, from $f_{P0}=k_0/T_0$ to $f_{PN}=k_0/T_N$. The computational complexity of the FEC decoder is accordingly increased as per equation [6].

As a result, applying a row-layered decoding scheme to LDPC codes with low coding rates might be prohibitive for implementation on DSP chips for next generation devices for optical coherent transmission working at up to 1 Tb/s.

In view of the above, it is an object of the present invention to provide a method and an optical coherent communication system for implementing a Forward Error Correction (FEC) mechanism having a variable coding rate, which solve the above drawback.

In particular, it is an object of the present invention to provide a method and an optical coherent communication system for implementing a Forward Error Correction (FEC) mechanism having a variable coding rate, wherein the computational complexity of the FEC decoder is substantially independent of the coding rate and is low enough to allow an implementation of the FEC decoder on a single DSP chip, even at very low coding rates (e.g. 0.5).

According to a first aspect, the present invention provides a method for implementing a FEC mechanism in an optical coherent communication system, the method comprising:

    a) at a FEC encoder of the system, encoding blocks of n client bits to be transmitted into codewords of n+k bits by adding k parity bits calculated by applying a FEC code to said n client bits; and
    b) at a FEC decoder of the system, decoding each codeword by applying thereto an iterative message-passing algorithm, each iteration of the message-passing algorithm comprising evaluating a parity-check matrix defining the FEC code,

wherein step a) comprises varying a coding rate of the FEC code by varying the number n of client bits per codeword and/or by varying the number k of parity bits per codeword; and
wherein step b) comprises, at each iteration of the message-passing algorithm, evaluating the parity-check matrix column by column.

Preferably, step a) comprises reducing the coding rate from a maximum starting value $R_0$, obtained by encoding blocks of $n_0$ client bits into codewords of $n_0+k_0$ bits by adding $k_0$ parity bits, to a new value $R_N < R_0$, obtained by encoding blocks of $n_N$ client bits into codewords of $n_N+k_N$ bits by adding $k_N$ parity bits.

Preferably, step a) comprises reducing the coding rate from the maximum starting value $R_0$ to the new value $R_N < R_0$ by reducing the number of client bits per codeword from $n_0$ to $n_N < n_0$.

According to preferred variants, step a) comprises applying an information shortening technique.

Preferably, step a) comprises reducing the coding rate from the maximum starting value $R_0$ to the new value $R_N < R_0$ by increasing the number of parity bits per codeword from $k_0$ to $k_N > k_0$.

Preferably, step a) comprises reducing the coding rate from the maximum starting value $R_0$ to the new value $R_N < R_0$ by increasing the number of parity bits per codeword from $k_0$ to $k_N > k_0$, and selecting $n_N$ and $k_N$ so that the number of bits per codeword is kept constant, namely $n_0+k_0=n_N+k_N$.

According to preferred variants, step a) comprises applying a code expanding technique.

Preferably, at step b) the iterative message-passing algorithm is a belief propagation algorithm.

According to a preferred variant, at step b) the belief propagation algorithm is a min-sum algorithm.

Preferably, at step b) the message-passing algorithm comprises a number $S \geq 2$ of iterations, each iteration of the message-passing algorithm comprising, for each codeword:

-   receiving a priori probabilities $I_v$ for the client bits and the parity bits of the codeword, v being an index ranging from 1 to n+k;
-   receiving extrinsic information $L_{cv}(i-1)$ for the client bits and the parity bits of the codeword as calculated at a preceding iteration of the message-passing algorithm, v being an index ranging from 1 to n+k and c being an index ranging from 1 to k.

Preferably, at step b) each intermediate iteration of the message-passing algorithm comprises:

- calculating updated extrinsic information $L_{cv}(i)$ for the client bits and the parity bits of the codeword based on the a priori probabilities $I_v$ and the extrinsic information $L_{cv}(i-1)$ calculated at the preceding iteration of said message-passing algorithm, v being an index ranging from 1 to n+k and c being an index ranging from 1 to k; and
- forwarding the a priori probabilities $I_v$ and the updated extrinsic information $L_{cv}(i)$ to a next iteration of the message-passing algorithm.

Preferably, calculating the updated extrinsic information $L_{cv}(i)$ comprises, for each one of n+k variable nodes representing a client bit or a parity bit of the codeword in a Tanner graph representing the FEC code:

- identifying a set M(v) of check nodes connected the said variable node in the Tanner graph; and
- calculating the updated extrinsic information $L_{cv}(i)$ as updated contents of variable-to-check messages $L_{cv}(i)$ from the variable node to the check nodes of said set M(v) by:

  - for each check node of the set M(v), calculating a content of a check-to-variable message $R_{cv}(i)$ from the check node to the variable node based on contents of variable-to-check messages $L_{cv}(i-1)$ from a set N(c) of variable nodes connected with the check node in the Tanner graph, as calculated at the preceding iteration of the message-passing algorithm; and
  - calculating the updated contents of the variable-to-check messages $L_{cv}(i)$ from the variable node to the check nodes of the set M(v) based on the a priori probabilities $I_v$ and the contents of the check-to-variable messages $R_{cv}(i)$ from the check nodes of the set M(v) to the variable node.

Preferably, at step b) a last iteration of the message-passing algorithm comprises:

- calculating a posteriori probabilities $L_v(i)$ for at least the client bits of the codeword, v being an index ranging from 1 to n+k; and
- forwarding the a posteriori probabilities $L_v(i)$ to a hard decision block using the a posteriori probabilities $L_v(i)$ for taking a decision "0" or "1" for each client bit of the codeword.

Preferably, calculating the a posteriori probabilities $L_v(i)$ comprises, for each one of n variable nodes representing a client bit of the codeword in the Tanner graph representing the FEC code:

- identifying a set M(v) of check nodes connected with the variable node in the Tanner graph; and
- calculating the a posteriori probabilities $L_v(i)$ by:

  - for each check node of the set M(v), calculating a content of a check-to-variable message $R_{cv}(i)$ from the check node to the variable node based on contents of variable-to-check messages $L_{cv}(i-1)$ from a set N(c) of variable nodes connected with the check node in said Tanner graph, as calculated at the preceding iteration of the message-passing algorithm; and

- calculating the a posteriori probabilities $L_v(i)$ based on the a priori probabilities $I_v$ and the contents of the check-to-variable messages $R_{cv}(i)$ from the check nodes of the set M(v) to the variable node.

According to a second aspect, the present invention provides an optical coherent communication system comprising:

- an optical transmitter comprising a FEC encoder configured to encode blocks of n client bits to be transmitted into codewords of n+k bits by adding k parity bits calculated by applying a FEC code to the n client bits; and
- an optical coherent receiver comprising a FEC decoder configured to decode each codeword by applying thereto an iterative message-passing algorithm, each iteration of the message-passing algorithm comprising evaluating a parity-check matrix defining the FEC code,

wherein the FEC encoder is configured to vary a coding rate of the FEC code by varying the number n of client bits per codeword and/or by varying the number k of parity bits per codeword; and

wherein the FEC decoder is configured to, at each iteration of the message-passing algorithm, evaluate the parity-check matrix column by column.

## Brief description of the drawings

Embodiments of the invention will be better understood by reading the following detailed description, given by way of example and not of limitation, to be read with reference to the accompanying drawings, wherein:

- Figure 1 (described above) schematically shows an increase of coding rate by the known information shortening technique;
- Figure 2 schematically shows an optical coherent communication system according to embodiments of the present invention;
- Figure 3 shows in further detail a decoding block of the FEC decoder included in the optical coherent receiver shown in Figure 1;
- Figure 4 is a flow chart of the operation of the decoding block shown in Figure 3; and
- Figure 5 shows two graphs of the computational complexity increase vs coding rate change with fixed client bitrate and with fixed line bitrate.

## Detailed description of preferred embodiments of the invention

Figure 2 shows an optical coherent communication system CS according to embodiments of the present invention.

The communication system CS preferably comprises an optical transmitter TX, an optical coherent receiver RX and an optical link OL connecting the optical transmitter TX and the optical coherent receiver RX.

The optical transmitter TX is preferably configured to transmit a number M of client channels on the optical link OL, e.g. using a WDM (Wavelength Division Multiplexing) technique. For each client channel, the optical transmitter TX preferably comprises a cascade of components including a FEC encoder, a modulator and a laser source. For simplicity, in Figure 2 only the FEC encoder FE of a single cascade is schematically depicted.

The optical coherent receiver RX is configured to receive the M client channels from the optical link OL. For each client channel, the optical coherent receiver RX preferably comprises a cascade of components including an analog unit, an analog-to-digital converter and a digital unit. The digital unit is typically implemented as a DSP chip comprising at least a demodulator and a FEC decoder. For simplicity, in Figure 2 only the FEC decoder FD of a single cascade is schematically depicted.

At the transmitter TX, the FEC encoder FE is configured to apply a FEC code (preferably, an LDPC code) to the stream of client bits to be transmitted on its client channel. The stream of bits (client bits and parity bits) output by the FEC encoder FE is then fed to the modulator cascaded with the FEC encoder FC (not shown in Figure 2), which translates it into a stream of modulation symbols determined according to a predefined modulation scheme (e.g. QAM, QPSK, etc.). Phases and amplitudes of the modulation symbols are then used for modulating an optical carrier generated by the laser source cascaded with the modulator (not shown in Figure 2). The modulated optical signal is then transmitted over the optical link OL.

At the receiver RX, the analog unit (not shown in Figure 2) receives the optical signal, mixes it with two local demodulation carriers, processes the result of the mixing and converts it into two analog electrical signals. The analog-to-digital converter (not shown in Figure 2) cascaded with the analog unit converts them into two digital electrical signals, which the digital unit then processes for retrieving the stream of client bits originally transmitted. In particular, the demodulator processes the two digital electrical signals to provide the FEC decoder FD with a priori probabilities (also termed "channel probabilities") of client bits and parity bits. The FEC decoder FD preferably applies to the received a priori probabilities an iterative message-passing algorithm, to provide a posteriori probabilities which finally allow taking a decision "0" or "1" for each client bit.

By referring again to the FEC encoder FE, the FEC encoder FE is preferably configured to encode blocks of n client bits into codewords of n+k bits by adding k parity bits calculated according to k parity checks. The coding rate of the LDPC coding applied by the FEC encoder FC is therefore $R=n/(n+k)$, as per equation [2] above.

Preferably, the coding rate of the FEC code applied by the FEC encoder FE is adjustable by adjusting the number of client bits per codeword and/or the number of parity bits per codeword. In particular, the coding rate of the FEC code applied by the FEC encoder FE is adjustable in a range having an upper limit $R_0$ by:

(i) reducing the number of client bits per codeword from a maximum value $n_0$ to a new value $n_N < n_0$; and/or
(ii) increasing the number of parity bits per codeword from a minimum value $k_0$ to a new value $k_N > k_0$.

Preferably, the reduction of the number of client bits per codeword from $n_0$ to the new value $n_N < n_0$ is performed by applying the known information shortening technique. Further, according to preferred embodiments, the increase of the number of parity bits per codeword from $k_0$ to $k_N > k_0$ is performed by applying the known code expanding technique.

According to a first embodiment, the codeword rate of the LDPC code applied by the FEC encoder FE is reduced from $R_0$ to $R_N$ by reducing the number of client bits per codeword from $n_0$ to the new value $n_N < n_0$ by applying the known information shortening technique, without any constraint on the codeword length. The codeword length accordingly varies with the coding rate. In particular, when the coding rate is reduced from $R_0$ to $R_N$ by reducing the number of client bits per codeword from $n_0$ to $n_N$, the codeword length is also reduced from $(n_0+k_0)$ to $(n_N+k_0)$.

According to this first embodiment, the coding rate may be varied in a range 0.6 - 0.8. For achieving still lower coding rates, the codeword length shall be kept constant, as it will be described in detail herein after.

As to the FEC decoder FD, it preferably comprises a number $S \geq 2$ of cascaded decoding blocks, each block being configured to perform a respective iteration of a message-passing algorithm, preferably a belief propagation algorithm. By way of non limiting example, the FEC decoder FD shown in Figure 1 comprises three decoding blocks DEC1, DEC2, DEC3. This is however not limiting. More generally, the number S of cascaded decoding blocks is determined as the number of iterations above which additional iterations entail a negligible improvement of the accuracy of the algorithm results. In any case, the upper limit of S is determined by the area available on the DSP chip on which the FEC decoder FD is implemented and by power consumption constraints.

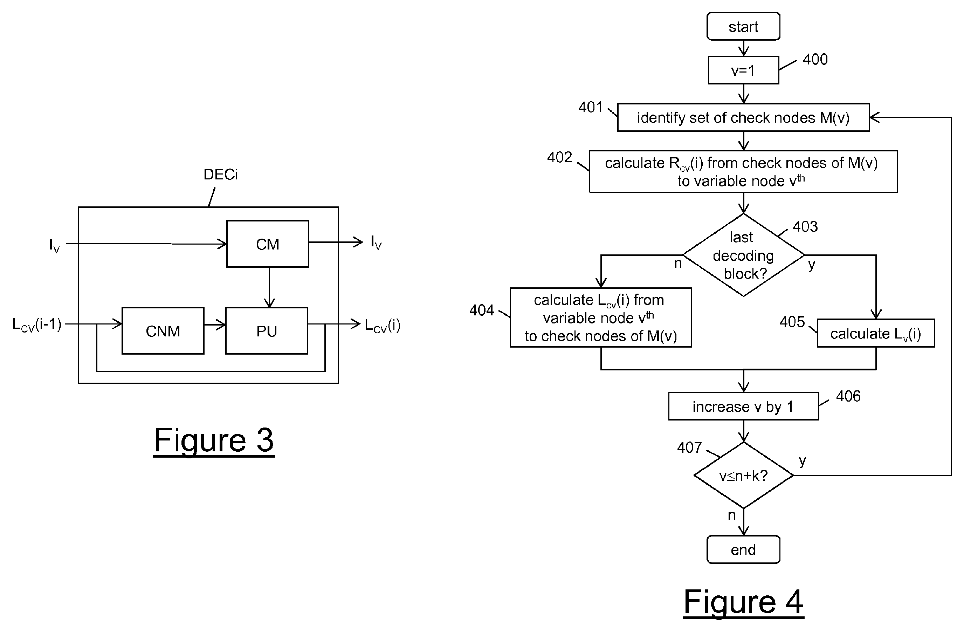

All decoding blocks DEC1, DEC2, DEC3 of the FEC decoder FD preferably have a same structure, which is schematically depicted in Figure 3. In particular, Figure 3 schematically shows the decoding block DECi, wherein i=1, 2, 3.

The decoding block DECi preferably comprises a channel memory unit CM, a check node memory unit CNM and a processing unit PU.

The channel memory unit CM is preferably unidirectionally connected with the processing unit PU, while the check node memory unit CNM is preferably connected with the processing unit PU according to a feedback configuration.

The channel memory unit CM is preferably connected to a first input and to a first output of the decoding block DECi. The check node memory unit CNM is preferably connected to a second input of the decoding block DECi, while the processing unit PU is connected to a second output of the decoding block DECi.

Under the assumption that the FEC encoder FE is applying an LDPC code providing codewords with n client bits and k parity bits, the decoding block DECi implementing the $i^{th}$ iteration of the decoding algorithm preferably receives from the preceding decoding block:

- a priori probabilities $I_v$ (or channel probabilities) of all the codeword bits (client bits and parity bits) of a codeword as provided by the demodulator preceding the FEC decoder FD, v being an index ranging from 1 to n+k; and
- extrinsic information $L_{cv}(i-1)$ for all the codeword bits as calculated by the preceding decoding block (namely, at the previous iteration of the algorithm), v being an index ranging from 1 to n+k and c being an index ranging from 1 to k. At the first decoding block DEC1, no extrinsic information is received (the FEC decoding is not started yet).

The decoding block DECi preferably stores the a priori probabilities $I_v$ in the channel memory unit CM and the extrinsic information $L_{cv}(i-1)$ in the check node memory unit CNM.

Then, if DECi is not the last decoding block of the FEC decoder, its processing unit PU preferably uses the a priori probabilities $I_v$ and the extrinsic information $L_{cv}(i-1)$ in order to calculate updated extrinsic information $L_{cv}(i)$ for the codeword bits. The decoding block DECi then preferably sends to the next decoding block:

- the a priori probabilities $I_v$ of the codeword bits; and
- the updated extrinsic information $L_{cv}(i)$ of the codeword bits.

Otherwise, if DECi is the last decoding block of the FEC decoder FD, its processing unit PU preferably uses the a priori probabilities $I_v$ and the extrinsic information $L_{cv}(i-1)$ in order to calculate a posteriori probabilities $L_v(i)$ for the codeword bits, in particular for the client bits of the codeword. The a posteriori probabilities $L_v(i)$ are then forwarded to a hard decision block.

According to a preferred embodiment, the a priori probabilities, extrinsic information and a posteriori probabilities of the codeword bits are expressed in terms of LLR, and the belief propagation algorithm implemented by the decoding block DECi is the known min-sum algorithm (MSA). Alternatively, the known sum-product algorithm (SPA) may be used.

In order to calculate the updated extrinsic information $L_{cv}(i)$ or the a posteriori probabilities $L_v(i)$ of the codeword bits, the processing unit PU of the decoding block DECi preferably scans the parity-check matrix defining the LDPC coding applied by the FEC encoder FE column by column.

More particularly, with reference to the flow chart of Figure 4, the processing unit PU preferably iterates the following procedure for each one of the n+k variable nodes of the Tanner graph representing the LDPC code applied by the FEC encoder FE.

Firstly, the processing unit PU preferably identifies the set M(v) of check nodes connected with the variable node $v^{th}$ in the Tanner graph (step 401).

Then, the processing unit PU preferably calculates the content of check-to-variable messages $R_{cv}(i)$ to be sent from the check nodes of the set M(v) to the variable node $v^{th}$ (step 402). According to a preferred embodiment, the content of the check-to-variable messages $R_{cv}(i)$ to be sent from check node $c^{th}$ of the set M(v) to the variable node $v^{th}$ is calculated according to the following equation:

$$R_{cv}(i) = \prod_{n \in N(c), n \neq v} \text{sgn}(L_{cn}(i-1)) \times \min_{n \in N(c), n \neq v} |L_{cn}(i-1)|, \qquad [7]$$

where $\text{sgn}(\cdot)$ is the sign function, N(c) is the set of variable nodes connected with the check node $c^{th}$ in the Tanner graph, n is an index ranging within the set N(c) and $L_{cn}(i)$ with $n \in N(n)$ are the contents of variable-to-check messages (namely, the extrinsic information) sent by the variable nodes of the set N(c) to the check node $c^{th}$ at the $i^{th}$ iteration. If the processing unit PU is performing the first iteration of the decoding algorithm (namely, it is included in the decoding block DEC1), the contents of the variable-to-check messages $L_{cn}(0)$ to be used at step 402 are preferably initialized at the respective a priori probabilities $I_n$, with n ranging in the set of variable nodes N(c) and $n \neq v$.

At step 402 the processing unit PU also preferably stores the calculated check-to-variable messages $R_{cv}(i)$ in the check node memory unit CNM.

Then, if DECi is not the last decoding block of the FEC decoder (403), its processing unit PU preferably calculates the content of variable-to-check messages $L_{cv}(i)$ (extrinsic information) to be sent from the variable node $v^{th}$ to the check nodes of the set M(v) (step 404). According to preferred embodiments, the content of the variable-to-check messages $L_{cv}(i)$ to be sent from variable node $v^{th}$ to check node $c^{th}$ of the set M(v) is calculated according to the following equation:

$$L_{cv}(i) = I_v + \alpha \sum_{m \in M(v), m \neq c} R_{mv}(i), \qquad [8]$$

where $I_v$ is the a priori probability of the client bit or parity bit associated with variable node $v^{th}$, $\alpha$ is a scaling factor, m is an index ranging within the set of check nodes M(v) and $R_{mv}(i)$ are the contents of the check-to-variable messages sent by the check nodes of the set M(v) to the variable node $v^{th}$ as calculated at step 402.

At step 404 the processing unit PU also preferably stores the calculated extrinsic information $L_{cv}(i)$ in the check node memory unit CNM.

Otherwise if DECi is the last decoding block of the FEC decoder (403), its processing unit PU preferably calculates an a posteriori probability $L_v(i)$ of the codeword bit associated with the variable node $v^{th}$ (step 405). According to preferred embodiments, the updated a posteriori probability $L_v(i)$ is calculated according to the following equation:

$$L_v(i) = I_v + \alpha \sum_{m \in M(v)} R_{mv}(i). \qquad [9]$$

Steps 401-405 are preferably iterated for each variable node of the Tanner graph, namely for each single bit of the codeword, independently of whether it is a client bit or a codeword bit. Hence, steps 401-405 are iterated n+k times, starting from an initial value 1 of the index v (step 400) and increasing it (step 406) until v=n+k (step 407).

Then, the algorithm iteration performed by the decoding block DECi ends. At the end of the algorithm iteration performed by the decoding block DECi, updated extrinsic information $L_{cv}(i)$ (intermediate decoding block) or a posteriori probability $L_v(i)$ (last decoding block) have been calculated by the processing unit PU for each codeword bit.

If DECi is not the last decoding block of the FEC decoder, the decoding block DECi may then send the calculated extrinsic information $L_{cv}(i)$ of the codewords bits to the next decoding block, which processes them by performing a further algorithm iteration similar to that shown in Figure 4.

If the decoding block DECi is instead the last decoding block of the FEC decoder (see block DEC3 in Figure 2), then the a posteriori probabilities $L_v(i)$ of the client bits of the codeword are sent to a hard decision block (not shown in the drawings for simplicity), while the a posteriori probabilities $L_v(i)$ of the parity bits of the codeword are discarded. The hard decision block then assigns a value 0 or 1 to each client bit, depending on its a posteriori probability. In case the probabilities are in the form of LLRs, the hard decision is based on the sign of the LLR, a positive LLR resulting in a client bit equal to 0 and a negative LLR resulting in a client bit equal to 1.

As mentioned above, according to the first embodiment the coding rate of the LDPC code applied by the FEC encoder FE may be decreased from $R_0$ to a lower value $R_N$ by reducing the number of client bits per codeword from $n_0$

to $n_N$ using the known information shortening technique.

As to FEC decoder FD, the number of operations to be computed for each received codeword by each decoding block DECi (namely, at each iteration of the belief propagation algorithm) equals n+k, namely the number of codeword bits, each operation corresponding to a respective column of the parity-check matrix. The FEC decoder FD is therefore advantageously agnostic of the ratio between number of client bits and number of parity bits in the codewords and its variations related to changes in the coding rate.

Hence, the FEC decoder FD may be advantageously adapted to work at any coding rate with few changes in its configuration, without the need to change hardware and without any change in its power consumption.

In particular, as the coding rate is reduced from $R_0$ to $R_N$, in order to reconfigure the FEC decoder FD to operate at the new coding rate $R_N$, in each decoding block DECi the addressing of the channel memory unit CM by the processing unit PU shall be changed as a function of the new codeword length, so that the processing unit PU may properly retrieve therefrom the a priori probabilities of each received codeword. On the other hand, in fixed client bitrate scenarios, as the coding rate is reduced from $R_0$ to $R_N$, the processing frequency of the processing unit PU adapts to the new line bitrate. As to the check node memory unit CNM of each decoding block DECi, its length depends exclusively on the number k of parity checks, and thus it does not change when the coding rate is reduced using the information shortening technique. Advantageously, these are the only changes needed in the configuration of the FEC decoder FD in order to enable it working at different coding rates.

As to the computational complexity of the FEC decoder FD, it can be expressed as:

$$C(\text{column}) = \frac{n+k}{T} = \frac{1}{R} \cdot \frac{n}{T} = \frac{f_C}{R} = f_L , \qquad [10]$$

where T is the codeword period, R is the coding rate of the LDPC code, $f_C$ is the client bitrate and $f_L$ is the line bitrate. The complexity of the FEC decoder FD therefore advantageously depends on the line bitrate $f_L$.

Hence, as the coding rate is reduced from its maximum value $R_0$ to $R_N$ using information shortening, the computational complexity of the FEC decoder FD scales with the coding rate as follows:

$$\frac{C_N(\text{column})}{C_0(\text{column}} = \frac{R_0}{R_N} \cdot \frac{f_{CN}}{f_{C0}} = \frac{f_{LN}}{f_{L0}} , \qquad [11]$$

where $f_{C0}$ and $f_{L0}$ are the client bitrate and line bitrate at the original coding rate Ro, whereas $f_{CN}$ and $f_{LN}$ are the client bitrate and line bitrate at the new, decreased coding rate $R_N < R_0$.

From equation [11] it is apparent that the computational complexity of the FEC decoder FD is independent or weakly dependent of the coding rate. This is because the computational complexity scales with the line bitrate $f_L$, which is independent of the coding rate in fixed line bitrate scenarios and is weakly dependent of the coding rate in fixed client bitrate scenarios.

In particular, in scenarios where the client bitrate $f_C$ is fixed, the increase of the parity bitrate $f_P$ due to the decrease of the coding rate from $R_0$ to $R_N$ results in an increased line rate from $f_{L0}$ to $f_{LN}$. However, when the coding rate is decreased from $R_0$ to a certain value $R_N$, the line bitrate $f_L$ is affected much less than the parity bitrate $f_P$. Hence, by comparing equation [6] with equation [11], it is apparent that the computational complexity of the FEC decoder FD depends on the coding rate much more weakly than a row-layered FEC decoder.

In scenarios where the line rate $f_L$ is fixed (as in Figure 1 described above), the increase of the parity bitrate $f_P$ due to the decrease of the coding rate from $R_0$ to $R_N$ has no impact at all on the line bitrate (it is "absorbed" by a corresponding decrease in the client rate $f_C$). The computational complexity of the FEC decoder FD accordingly does not change and is completely independent of the coding rate.

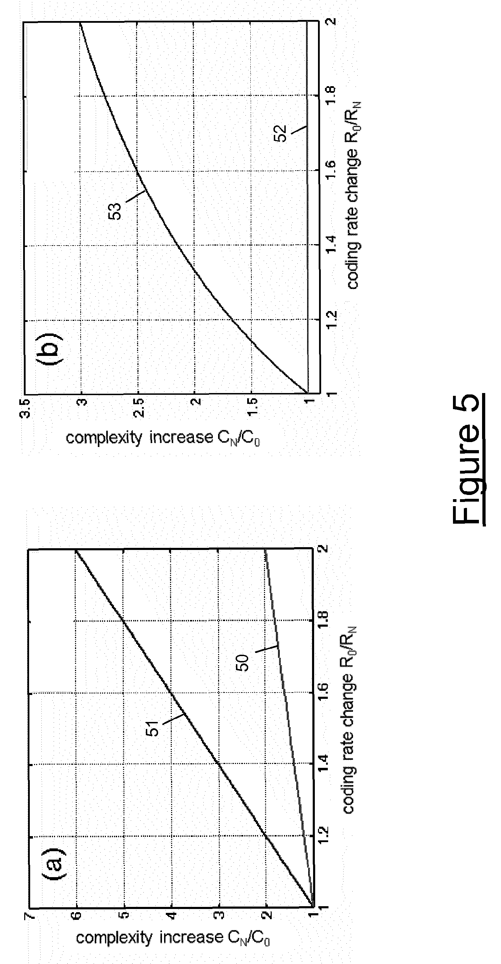

Figure 5(a) is a graph showing how the computational complexity of the FEC decoder FD scales with the coding rate, assuming an original coding rate $R_0 = 0.8$ and fixed client bitrate $f_C$ (curve 50). The graph also shows a comparative curve 51 relating to a row-layered FEC decoder. It may be appreciated that, as discussed above, the complexity of the FEC decoder FD depends on the coding rate much more weakly than a row-layered FEC decoder.

Figure 5(b) is a graph showing how the complexity of the FEC decoder FD scales with the coding rate, assuming an original coding rate $R_0 = 0.8$ and fixed line bitrate $f_L$ (curve 52). The graph also shows a comparative curve 53 relating to a row-layered FEC decoder. It may be appreciated that, as discussed above, the computational complexity of the FEC decoder FD is completely independent of the coding rate.

Moreover, it shall be noticed that the calculation of check-to-variable messages and variable-to-check messages shown in Figure 4 and described above comprises a number of operations lower than the number of operations required by the calculation of check-to-variable messages and variable-to-check messages according to a row-layered scheme.

This is because the number of variables required for the calculation can be limited to three variable with negligible loss of performance, while 15 variables about are required in row-layered decoding for obtaining a same performance. Therefore, even if the number of columns of the parity-check matrix is n+k and is accordingly inherently higher than the number of rows (k), the overall number of operations to be performed in a single iteration of the decoding algorithm is lower according to the flow chart of Figure 4 than in a row-layered FEC decoder.

Therefore, in addition to having a computational complexity which weakly scales (or does not scale at all, if the line bitrate $f_L$ is fixed) with the coding rate, the FEC decoder FD also exhibits a computational complexity whose absolute value is comparable to that of a row-layered FEC decoder.

In the embodiment described above, the coding rate is reduced from $R_0$ to $R_N$ by reducing the number of client bits per codeword from $n_0$ to $n_N$ with no constrains on the resulting codeword length, which accordingly decreases from $n_0+k_0$ to $n_N+k_0$. The Applicant has noticed that this allows varying the coding rate in a range 0.6-0.8. However, for obtaining still lower coding rates (lower than 0.6, e.g. 0.5), the codeword length becomes short and some known limitations of the decoder performance (coding gain) inherent to the use of short codewords arise.

In order to reach coding rates lower than 0.6 while overcoming such limitations, according to a second embodiment of the present invention the coding rate of the LDPC code applied by the FEC encoder FE at the transmitter TX is varied while keeping the codeword length constant.

At this purpose, according to the second embodiment, the coding rate is adjusted by combining a reduction of the number of client bits per codeword from $n_0$ to $n_N$ and an increase of the number of parity bits per codeword from $k_0$ to $k_N$, with the constraint that $n_0+k_0=n_N+k_N$.

Preferably, the number of client bits per codeword is reduced by applying the known information shortening technique, while the number of parity bits per codeword is increased by applying the known code expanding technique.

The FEC decoder according to the second embodiment has the same structure as the FEC decoder FD shown in Figure 2. Use of the channel memory unit CM is however different. In particular, the addressing of the channel memory unit CM does not need to be reconfigured when the coding rate is changed, because the number of a priori probability values that must be read from the channel memory unit CM for each received codeword is $n_0+k_0$, independently of the coding rate. The addressing of the check node memory unit CNM shall be instead reconfigured as the coding rate is changed, because it depends on the number of parity bits per codeword, which is changed from $k_0$ to $k_N$.

Therefore, also according to the second embodiment, FEC encoding with variable coding rate is combined with a FEC decoding evaluating the parity-check matrix column by column. Since the number of columns in the parity-check matrix depends on the codeword length, when the coding rate is changed while keeping the codeword length fixed the FEC decoder performs exactly the same number of operations per codeword period, at each iteration of the decoding algorithm. Hence, also according to the second embodiment the complexity of the FEC decoder scales with the coding rate as per equation [11] above.

Also this second embodiment may be applied either at a fixed line rate scenario or to a fixed client bitrate scenarios.

**Claims**

1. A method for implementing a forward error correction (FEC) mechanism in an optical coherent communication system (CS), said method comprising:

   a) at a FEC encoder (FE) of said system (CS), encoding blocks of n client bits to be transmitted into codewords of n+k bits by adding k parity bits calculated by applying a FEC code to said n client bits; and
   b) at a FEC decoder (FD) of said system (CS), decoding each codeword by applying thereto an iterative message-passing algorithm, each iteration of said message-passing algorithm comprising evaluating a parity-check matrix defining said FEC code,

   wherein step a) comprises varying a coding rate of said FEC code by varying said number n of client bits per codeword and/or by varying said number k of parity bits per codeword; and
   wherein step b) comprises, at each iteration of said message-passing algorithm, evaluating said parity-check matrix column by column.

2. The method according to claim 1, wherein step a) comprises reducing said coding rate from a maximum starting value $R_0$, obtained by encoding blocks of $n_0$ client bits into codewords of $n_0+k_0$ bits by adding $k_0$ parity bits, to a new value $R_N<R_0$, obtained by encoding blocks of $n_N$ client bits into codewords of $n_N+k_N$ bits by adding $k_N$ parity bits.

3. The method according to claim 2, wherein step a) comprises reducing said coding rate from said maximum starting

value $R_0$ to said new value $R_N < R_0$ by reducing the number of client bits per codeword from $n_0$ to $n_N < n_0$.

4. The method according to claim 3, wherein step a) comprises applying an information shortening technique.

5. The method according to claim 2, wherein step a) comprises reducing said coding rate from said maximum starting value $R_0$ to said new value $R_N < R_0$ by increasing the number of parity bits per codeword from $k_0$ to $k_N > k_0$.

6. The method according to claim 3 or 4, wherein step a) comprises reducing said coding rate from said maximum starting value $R_0$ to said new value $R_N < R_0$ by increasing the number of parity bits per codeword from $k_0$ to $k_N > k_0$, and selecting $n_N$ and $k_N$ so that the number of bits per codeword is kept constant, namely $n_0 + k_0 = n_N + k_N$.

7. The method according to claim 5 or 6, wherein step a) comprises applying a code expanding technique.

8. The method according to any of the preceding claims, wherein at step b) said iterative message-passing algorithm is a belief propagation algorithm.

9. The method according to claim 8, wherein at step b) said belief propagation algorithm is a min-sum algorithm.

10. The method according to claims 8 or 9, wherein at step b) said message-passing algorithm comprises a number $S \geq 2$ of iterations, each iteration of said message-passing algorithm comprising, for each codeword:

- receiving a priori probabilities $I_V$ for said client bits and said parity bits of said codeword, v being an index ranging from 1 to n+k;
- receiving extrinsic information $L_{CV}(i-1)$ for said client bits and said parity bits of said codeword as calculated at a preceding iteration of said message-passing algorithm, v being an index ranging from 1 to n+k and c being an index ranging from 1 to k.

11. The method according to claim 10, wherein at step b) each intermediate iteration of said message-passing algorithm comprises:

- calculating updated extrinsic information $L_{cv}(i)$ for said client bits and said parity bits of said codeword based on said a priori probabilities $I_v$ and said extrinsic information $L_{cv}(i-1)$ calculated at said preceding iteration of said message-passing algorithm, v being an index ranging from 1 to n+k and c being an index ranging from 1 to k; and
- forwarding said a priori probabilities $I_v$ and said updated extrinsic information $L_{cv}(i)$ to a next iteration of said message-passing algorithm.

12. The method according to claim 11, wherein said calculating said updated extrinsic information $L_{cv}(i)$ comprises, for each one of n+k variable nodes representing a client bit or a parity bit of said codeword in a Tanner graph representing said FEC code:

- identifying a set M(v) of check nodes connected with said variable node in said Tanner graph; and
- calculating said updated extrinsic information $L_{cv}(i)$ as updated contents of variable-to-check messages $L_{cv}(i)$ from said variable node to the check nodes of said set M(v) by:

- for each check node of said set M(v), calculating a content of a check-to-variable message $R_{cv}(i)$ from said check node to said variable node based on contents of variable-to-check messages $L_{cv}(i-1)$ from a set N(c) of variable nodes connected with said check node in said Tanner graph, as calculated at said preceding iteration of said message-passing algorithm; and
- calculating said updated contents of said variable-to-check messages $L_{cv}(i)$ from said variable node to the check nodes of said set M(v) based on said a priori probabilities $I_v$ and said contents of said check-to-variable messages $R_{cv}(i)$ from the check nodes of said set M(v) to said variable node.

13. The method according to claim any of claims 10 to 12, wherein at step b) a last iteration of said message-passing algorithm comprises:

- calculating a posteriori probabilities $L_v(i)$ for at least said client bits of said codeword, v being an index ranging from 1 to n+k; and

- forwarding said a posteriori probabilities $L_v(i)$ to a hard decision block using said a posteriori probabilities $L_v(i)$ for taking a decision "0" or "1" for each client bit of said codeword.

14. The method according to claim 13, wherein said calculating said a posteriori probabilities $L_v(i)$ comprises, for each one of n variable nodes representing a client bit of said codeword in said Tanner graph representing said FEC code:

- identifying a set M(v) of check nodes connected with said variable node in said Tanner graph; and
- calculating said a posteriori probabilities $L_v(i)$ by:

- for each check node of said set M(v), calculating a content of a check-to-variable message $R_{cv}(i)$ from said check node to said variable node based on contents of variable-to-check messages $L_{cv}(i-1)$ from a set N(c) of variable nodes connected with said check node in said Tanner graph, as calculated at said preceding iteration of said message-passing algorithm; and
- calculating said a posteriori probabilities $L_v(i)$ based on said a priori probabilities $I_v$ and said contents of said check-to-variable messages $R_{cv}(i)$ from the check nodes of said set M(v) to said variable node.

15. An optical coherent communication system (CS) comprising:

- an optical transmitter (TX) comprising a FEC encoder (FE) configured to encode blocks of n client bits to be transmitted into codewords of n+k bits by adding k parity bits calculated by applying a FEC code to said n client bits; and
- an optical coherent receiver (RX) comprising a FEC decoder (FD) configured to decode each codeword by applying thereto an iterative message-passing algorithm, each iteration of said message-passing algorithm comprising evaluating a parity-check matrix defining said FEC code,

wherein said FEC encoder (FE) is configured to vary a coding rate of said FEC code by varying said number n of client bits per codeword and/or by varying said number k of parity bits per codeword; and

wherein said FEC decoder (FD) is configured to, at each iteration of said message-passing algorithm, evaluate said parity-check matrix column by column.

**Figure 1**

**Figure 2**

EP 3 264 610 A1

**Figure 3**

DECi

$I_v$ → CM → $I_v$

$L_{CV}(i-1)$ → CNM → PU → $L_{CV}(i)$

**Figure 4**

start

v=1 — 400

401 — identify set of check nodes M(v)

402 — calculate $R_{cv}(i)$ from check nodes of M(v) to variable node $v^{th}$

403 — last decoding block?

n → 404 — calculate $L_{cv}(i)$ from variable node $v^{th}$ to check nodes of M(v)

y → 405 — calculate $L_v(i)$

increase v by 1 — 406

407 — v≤n+k?

y

n

end

Figure 5

Europäisches
Patentamt
European
Patent Office
Office européen
des brevets

**EUROPEAN SEARCH REPORT**

Application Number

EP 16 30 5774

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KACHRIS CHRISTOFOROS ET AL: "Reconfigurable FEC codes for software-defined optical transceivers", PROC., IEEE 13TH INTERNATIONAL CONFERENCE ON OPTICAL COMMUNICATIONS AND NETWORKS (ICOCN), 9 November 2014 (2014-11-09), pages 1-4, XP032709182, DOI: 10.1109/ICOCN.2014.6987087 [retrieved on 2014-12-15] | 1-3,5,6, 8-15 | INV. H03M13/11 H03M13/00  ADD. H04L1/00 |
| A | * the whole document * | 4,7 | |
| X | SUGIHARA KENYA ET AL: "A practicable rate-adaptive FEC scheme flexible about capacity and distance in optical transport networks", PROC., OPTICAL FIBER COMMUNICATIONS CONFERENCE AND EXHIBITION, OFC, OPTICAL SOCIETY OF AMERICA, 20 March 2016 (2016-03-20), pages 1-3, XP032942303, [retrieved on 2016-08-09] * the whole document * | 1-15 | |
| A | LI RONGCHUN ET AL: "A multi-standard efficient column-layered LDPC decoder for Software Defined Radio on GPUs", PROC., IEEE 14TH WORKSHOP ON SIGNAL PROCESSING AND ADVANCES IN WIRELESS COMMUNICATIONS, SPAWC, 16 June 2013 (2013-06-16), pages 724-728, XP032490422, ISSN: 1948-3244, DOI: 10.1109/SPAWC.2013.6612145 [retrieved on 2013-09-25] * the whole document * | 1-15 | TECHNICAL FIELDS SEARCHED (IPC)  H03M H04L |

-/--

The present search report has been drawn up for all claims

| Place of search | Date of completion of the search | Examiner |
|---|---|---|
| Munich | 14 December 2016 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 16 30 5774

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | VILA CASADO A I ET AL: "Multiple rate low-density parity-check codes with constant blocklength", RROC., IEEE THIRTY- EIGHTH ASILOMAR CONFERENCE ON SIGNALS, SYSTEMS AND COMPUTERS,PACIFIC GROVE, CA, USA, vol. 2, 7 November 2004 (2004-11-07), - 10 November 2002 (2002-11-10), pages 2010-2014, XP010781157, DOI: 10.1109/ACSSC.2004.1399517 ISBN: 978-0-7803-8622-8 * the whole document * ----- | 1-15 | |
| A | US 2010/325511 A1 (OH JONG-EE [KR] ET AL) 23 December 2010 (2010-12-23) * the whole document * ----- | 1-15 | |

**TECHNICAL FIELDS SEARCHED (IPC)**

The present search report has been drawn up for all claims

| Place of search | Date of completion of the search | Examiner |
|---|---|---|
| Munich | 14 December 2016 | Offer, Elke |

EPO FORM 1503 03.82 (P04C01)

# EP 3 264 610 A1

## ANNEX TO THE EUROPEAN SEARCH REPORT
## ON EUROPEAN PATENT APPLICATION NO.

EP 16 30 5774

14-12-2016

| Patent document cited in search report | Publication date | Patent family member(s) | Publication date |
|---|---|---|---|
| US 2010325511 A1 | 23-12-2010 | KR 100833515 B1<br>US 2010325511 A1 | 29-05-2008<br>23-12-2010 |

EPO FORM P0459

For more details about this annex : see Official Journal of the European Patent Office, No. 12/82